Europäisches Patentamt

European Patent Office

Office européen des brevets

(11) Veröffentlichungsnummer: **0 164 090 B1**

# (12) EUROPÄISCHE PATENTSCHRIFT

(45) Veröffentlichungstag der Patentschrift: **13.03.91**

(51) Int. Cl.⁵: **H01L 31/06, H01L 31/02**

(21) Anmeldenummer: **85106838.7**

(22) Anmeldetag: **03.06.85**

(54) Solarzelle.

(30) Priorität: **05.06.84 DE 3420887**

(43) Veröffentlichungstag der Anmeldung:
**11.12.85 Patentblatt 85/50**

(45) Bekanntmachung des Hinweises auf die
Patenterteilung:
**13.03.91 Patentblatt 91/11**

(84) Benannte Vertragsstaaten:
**FR GB IT NL**

(56) Entgegenhaltungen:
GB-A- 2 034 973
GB-A- 2 119 167

APPLIED PHYSICS LETTERS, Band 41, Nr. 4,
15. August 1982, Seiten 365-366, American
Institute of Physics, New York, US; P.H.
FANG et al.: "Combined microcrystal and
amorphous silicon cells"

JAPANESE JOURNAL OF APPLIED PHYSICS,
Band 21, Nr. 9, September 1982, Seiten
L586-L588, Tokyo, JP; Y. UCHIDA et al.:
"Microcrystalline Si: H film and its application to solar cells"

(73) Patentinhaber: **TELEFUNKEN SYSTEMTECHNIK
GMBH
Sedanstrasse 10
W-7900 Ulm (Donau)(DE)**

(72) Erfinder: **Rasch, Klaus-Dieter, Dr. rer. nat.
Hundsbergstrasse 10/1
W-7129 Talheim(DE)**
Erfinder: **Strobl, Gerhard, Dipl.-Ing.
Halligenstrasse 59
W-7000 Stuttgart 40(DE)**

(74) Vertreter: **Schulze, Harald Rudolf, Dipl.-Ing.
TELEFUNKEN SYSTEMTECHNIK GMBH Sedanstrasse 10
W-7900 Ulm(DE)**

EP 0 164 090 B1

IEEE TRANSACTIONS ON ELECTRON DEVI-CES, Band ED-25, Nr. 5, Mai 1978, Seiten 507-511, IEEE, New York, US; P. VAN HALEN et al.: "New TiOx-MIS and SiO2-MIS silicon solar cells"

IEEE TRANSACTIONS ON ELECTRON DEVI-CES, Band ED-25, Nr. 11, November 1978, Seiten 1308-1317, IEEE, New York, US; D.L. PULFREY: "MIS solar cells: a review"

PATENT ABSTRACTS OF JAPAN, Band 8, Nr. 250 (E-279)[1687], 16. November 1984; & JP-A-59 125 668 (SANYO DENKI K.K.) 20-07-1984

## Beschreibung

Die Erfindung betrifft eine Solarzelle aus einem einen pn-Übergang enthaltenden Halbleiterkörper, wobei eine dem Licht zugewandte dünne Oberflächenzone eines Leitungstyps eine Metallisierung aufweist, die kammartig ausgebildet ist, einem Rückseitenkontakt und einer reflexionsmindernden Schicht.

Zur Umwandlung von Sonnenenergie in elektrische Energie werden heute hauptsächlich ein- oder polykristalline Siliziumsolarzellen mit einem Wirkungsgrad von ca. 14 % verwendet. Wirkungsgradverluste ergeben sich unter anderem durch Reflexionsverluste, unvollständige Absorption, teilweise Ausnutzung der Photonenenergie, Rekombination generierter Ladungsträger, Abweichung des Bandabstands des Ausgangsmaterials vom idealen Optimum von 1,4 eV etc.

Zur besseren Ausnutzung des AM1-Spektrums (air-mass-1) - Sonnenspektrum nach Absorption in der Atmosphäre bezogen auf Meereshöhe bei höchstem Sonnenstand - erreicht man mit Solarzellen auf der Basis von Galliumarsenid wegen seines fast idealen Bandabstands von 1,43 eV einen Wirkungsgrad von ca. 22 %. Für die Massenproduktion ist die Herstellung von Galliumarsenid-Solarzellen noch relativ teuer.

Um eine wirtschaftliche Produktion von Solarzellen zu ermöglichen, wurden bereits Versuche mit amorphem Silizium unternommen. Der Grund liegt hierfür in der verbilligten Herstellung des Ausgangsmaterials, im geringen Materialverbrauch sowie in der Möglichkeit der Massenproduktion.

Mit aus amorphem Silizium gefertigten Solarzellen konnte in der Serienfertigung ein Wirkungsgrad von nur 5,5 % erreicht werden. GB-A 21 19 167 und Appl. Phys. Lett. 41(4), 15. August 1982, Seiten 365-366 beschreiben amorphe Siliziumsolarzellen mit einer p-i-n-Schichtfolge, die mit einer Schicht von amorphem bzw. mikrokristallinem Silizium zwischen Metallisierung und amorpher p-i-n-Schichtenfolge ausgerüstet sind, um die Oberflächenrekombination herabzusetzen und somit den Wirkungsgrad zu erhöhen.
Jedoch ist der Wirkungsgrad von herkömmlichen ein- oder polykristallinen Siliziumsolarzellen immer noch unbefriedigend.

Deshalb liegt der vorliegenden Erfindung die Aufgabe zugrunde, eine wirtschaftliche Solarzelle mit einem gegenüber herkömmlichen Solarzellen gesteigerten Wirkungsgrad anzugeben.

Diese Aufgabe wird erfindungsgemäß bei einer Solarzelle der eingangs erwähnten Art dadurch gelöst, daß eine amorphe oder mikrokristalline Siliziumschicht unter der reflexionsmindernden Schicht und über der Metallisierung bzw. zwischen der Oberflächenzone und der Isolierschicht angeordnet ist.

Durch diese Maßnahmen erfolgt eine relativ wirtschaftliche Erhöhung des Wirkungsgrads einer Solarzelle, dadurch, daß Rekombinationszentren reduziert werden.

Dies kann in vorteilhaften Weiterbildungen dadurch geschehen, daß die amorphe oder mikrokristalline Siliziumschicht entweder unmittelbar unter der reflexionsmindernden Schicht oder unmittelbar über der dünnen Oberflächenzone eines Leitungstyps angeordnet ist. Der Halbleiterkörper der Solarzelle besteht vorzugsweise aus dotiertem Silizium oder Galliumarsenid, wobei der Halbleiterkörper ein- oder polykristallin sein kann.

Durch Hydrieren mit Wasserstoff zur Absättigung von freien Valenzen, Zugabe von Kohlenstoff zur Erzeugung eines optischen Fensters mit einem Bandabstand von ca. 3 eV läßt sich die Oberflächenrekombinationsgeschwindigkeit an der dem Lichteinfall zugewandten Seite der dünnen Oberflächenzone besonders gut herabsetzen.

Durch Dotieren mit beispielsweise Phosphor steht die amorphe oder mikrokristalline Siliziumschicht auch für den Ladungsträgertransport zur Verfügung. Dadurch ist es möglich, die dünne Oberflächenzone einer Solarzelle dünner zu machen, wodurch eine bessere Ausnutzung des kurzwelligen Anteils des Spektrums erfolgt und gleichzeitig ist es möglich, die dünne Oberflächenzone schwächer zu dotieren, um Hochdotierungseffekte an der Oberfläche dieser Zone und den damit verknüpften Rekombinationszentren zu vermeiden.

Weitere vorteilhafte Ausgestaltungen der Erfindung und deren Herstellungsverfahren ergeben sich aus den Unteransprüchen.

Ausführungsbeispiele der Erfindung sind in den Figuren dargestellt und werden im folgenden näher beschrieben.
Es zeigen:

Figur 1:    Eine perspektivische Darstellung einer Solarzelle nach dem Stand der Technik.

Figur 2:    Eine Schichtenstruktur einer Solarzelle mit einer amorphen oder mikrokristallinen Siliziumschicht 4.

Figur 3:    Eine Schichtenstruktur einer Solarzelle mit einer dotierten amorphen oder mikrokristallinen Siliziumschicht 4.

Figur 4:    Eine Schichtenstruktur einer Solarzelle mit einer dotierten amorphen oder mikrokristallinen Siliziumschicht 4, bei der diese Schicht unmittelbar über der dünnen Oberflächenzone 2 angeordnet ist.

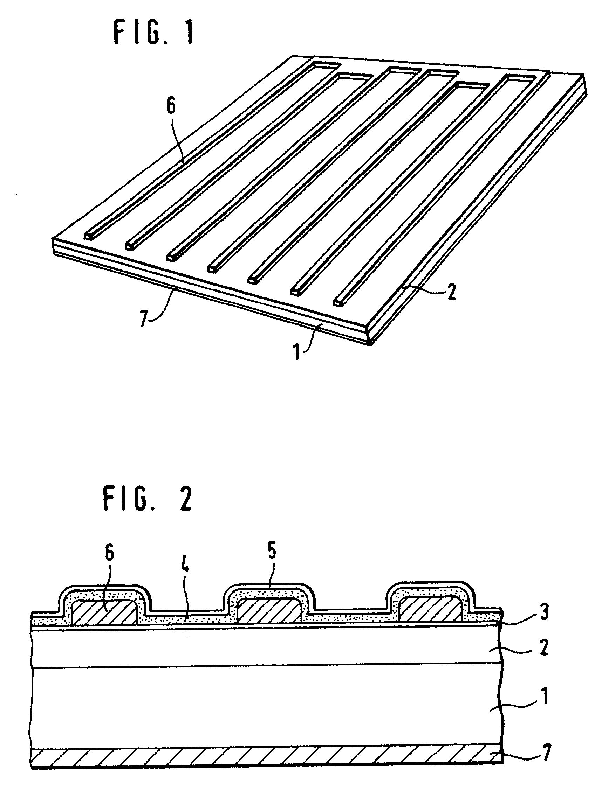

Figur 1 zeigt den prinzipiellen Aufbau einer Solarzelle nach dem Stand der Technik, bestehend aus einem Halbleiterkörper 1, 2 mit einer dünnen Oberflächenzone 2 vom einen Leitungstyp, einer kammartigen Metallisierung 6, die unmittelbar auf die dünne Oberflächenzone 2 aufgebracht und dem einfallenden Licht zugewandt ist und einem ganzflächigen Rückseitenkontakt 7, der auf dem Substrat 1 vom anderen Leitungstyp des Halbleiterkörpers 1, 2 angeordnet ist.

Der Halbleiterkörper 1, 2 der Solarzelle in der Figur 2 besteht beispielsweise aus ein- oder polykristallinem Silizium, wobei das Substrat 1 mit ca. $10^{15}$ Atome/cm$^3$ p-dotiert und die dünne Oberflächenzone 2 mit ca. $10^{20}$ Atome/cm$^3$ stark n$^+$-dotiert ist. Der Halbleiterkörper 1, 2 hat eine Dicke von ca. 200 $\mu$m, wobei auf die dünne Oberflächenzone 2 ca. 0,5 $\mu$m entfallen. Als Dotierstoff im Substrat 1 wird vorzugsweise Bor und in der dünnen Oberflächenzone 2 Phosphor verwendet. Es sind jedoch auch andere Dotierstoffe aus der dritten bzw. fünften Gruppe des Periodensystems denkbar.

Unmittelbar auf die dünne Oberflächenzone 2 ist eine extrem dünne Schicht 3 aus Siliziumdioxid mit einer Schichtdicke von ca. 2 nm aufgebracht, die mit den darauffolgenden Kontaktfingern der Metallisierung 6 eine MIS-Struktur bildet und dadurch Minoritätsladungsträger begünstigt und Majoritätsladungsträger behindert.

Auf die Kontaktfinger der Metallisierung 6 und auf die extrem dünne Schicht 3 aus Siliziumdioxid ist eine amorphe oder mikrokristalline Siliziumschicht 4 mit einer Schichtdicke von ca. 0,05 - 0,005 $\mu$m aufgebracht. Durch Hydrieren mit Wasserstoff sind bei ihr freie Valenzen abgesättigt und durch die Zugabe von vorzugsweise Kohlenstoff läßt sich der Bandabstand auf bis zu 3 eV erhöhen, wodurch diese Schicht kein einfallendes Licht absorbieren kann und als optisches Fenster wirkt.

Die amorphe oder mikrokristalline und in diesem Fall undotierte Siliziumschicht 4 verringert auf der dem einfallenden Licht zugewandten Seite der dünnen Oberflächenzone 2, die aus kristallinem Silizium besteht, die Oberflächenrekombinationsgeschwindigkeit, wodurch mehr Ladungsträgerpaare in der Nähe des pn-Übergangs erzeugt werden. Als Folge davon erhöhen sich mittelbar Spannung und Strom der so strukturierten Solarzelle, was sich in einer Wirkungsgraderhöhung niederschlägt.

Über der amorphen bzw. mikrokristallinen Siliziumschicht 4 ist eine reflexionsmindernde Schicht 5, die beispielsweise Titanoxid, Siliziummonoxid, Siliziumdioxid, Tantaloxid, Nioboxid, Aluminiumoxid bzw. aus der Ein- oder Mehrschichtenkombination dieser Materialien bestehen kann, angeordnet.

Auf der dem einfallenden Licht abgewandten Seite der Solarzelle ist ein Rückseitenkontakt 7 angebracht, der aus dem gleichen Material wie die Metallisierung 6 besteht, welche sich z. B. aus Aluminium, Silber, Nickel, Kupfer oder aus einer Schichtenfolge von Titan-Palladium-Silber zusammensetzt. Die gesonderten Verbindungselemente für den Aufbau einer Solarzellenbatterie können aus denselben Materialien bestehen. Die Metallisierung 6 kann gemäß der Figur 1 kammartig ausgebildet sein, wobei ein Einzelsteg eine Querschnittshöhe von ca. 10 $\mu$m und eine Breite von 6 bis 10 $\mu$m haben kann.

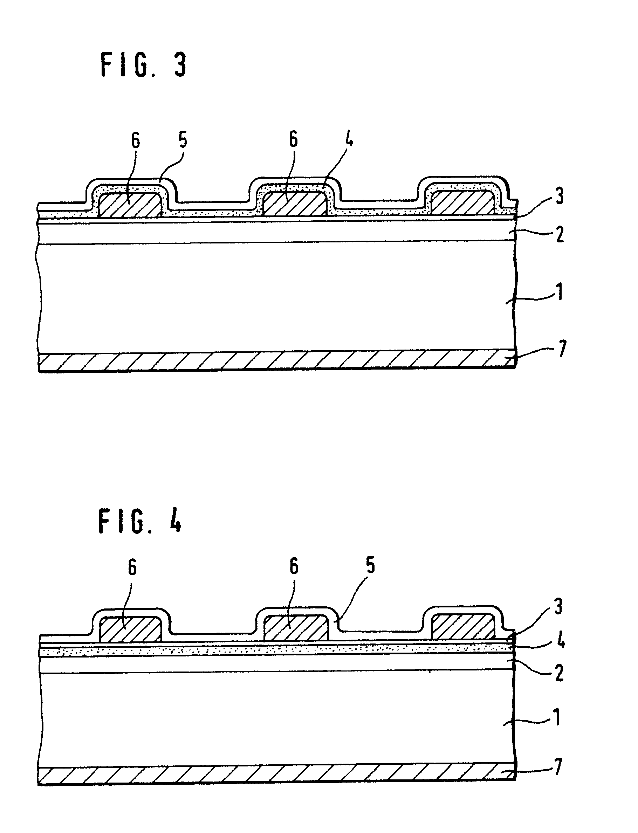

In der Figur 3 ist eine Schichtenfolge für eine Solarzelle angegeben, die prinzipiell den gleichen Aufbau hat wie die Solarzelle gemäß Figur 2. Jedoch sind im Gegensatz zu Figur 2 zwei Unterschiede festzustellen.

1. Die amorphe oder mikrokristalline Siliziumschicht 4 ist dotiert mit ca. $10^{20}$ Atome/cm$^3$, wobei entweder eine p- bzw. n-Dotierung möglich ist mit Elementen der dritten bzw. fünften Gruppe des Periodensystems.

2. Die dünne Oberflächenzone 2 der Solarzelle ist mit ca. 0,25 $\mu$m wesentlich dünner als die in Figur 2 und sie ist außerdem mit ca. $10^{19}$ Atome/cm$^3$ schwächer dotiert.

Durch diese Maßnahmen wird der kurzwellige Anteil des Sonnenspektrums besser ausgenutzt, da die kurzwellige Strahlung zur Erzeugung von Ladungsträgerpaaren dadurch nicht bereits nahe der Oberfläche der dünnen Oberflächenzone 2 absorbiert wird.

Außerdem werden durch diese Maßnahmen Hochdotierungseffekte an der Oberfläche der dünnen Oberflächenzone (2) umgangen.

Da die amorphe oder mikrokristalline Siliziumschicht (4) hierbei dotiert ist, steht sie somit zum Ladungsträgertransport zur Verfügung, wodurch die durch die oben genannten Maßnahmen bedingte Erhöhung des Schichtwiderstands der dünnen Oberflächenzone (2) weitgehend kompensiert wird.

In der Figur 4 ist eine Schichtenstruktur für eine Solarzelle, die eine Modifikation zu den Solarzellen gemäß Figur 2 und 3 darstellt, angegeben.

Der Halbleiterkörper (1), (2) besteht wiederum aus ein- oder polykristallinem Silizium, wobei das Substrat (1) mit ca. $10^{15}$ Atome/cm$^3$ p-dotiert und die dünne Oberflächenzone (2) mit ca. $10^{20}$ Atome/cm$^3$ stark n$^+$-dotiert ist. Der Halbleiterkörper (1), (2) hat eine Dicke von ca. 200 $\mu$m, wobei auf die dünne Oberflächenzone (2) ca. 0,25 $\mu$m entfallen. Als Dotierstoff im Substrat (1) wird vorzugsweise Bor und in der dünnen Oberflächenzone (2) Phosphor verwendet. Unmittelbar auf die dünne Oberflächenzone (2) ist die ca. 0,05 - 0,005 $\mu$m dicke dotierte amorphe oder mikrokristalline Siliziumschicht (4) aufgebracht. Sie enthält Zusätze von Wasserstoff, Kohlenstoff und ist mit ca. $10^{20}$ Atome/cm$^3$ p- oder n-dotiert. Unmittelbar auf die amorphe oder mikrokristalline Siliziumschicht (4) folgt eine extrem dünne Schicht (3) aus Siliziumdioxid mit ca. 2 nm Dicke, wodurch sich mit der darauffolgenden Metallisierung (6) eine MIS-Struktur ergibt, die Minoritätsladungsträger begünstigt und Majoritätsladungsträger behindert.

Die Metallisierung (6) ist dabei ebenfalls kammartig ausgebildet und von einer reflexionsmindernden Schicht (5) überzogen, die die gleiche Materialzusammensetzung hat wie die Solarzelle gemäß Figur 2 oder 3.

Zur besseren Ausnutzung eines AM1-Spektrums ist für den Aufbau des Halbleiterkörpers (1), (2) wegen seines fast idealen Bandabstands von 1,43 eV Galliumarsenid auch sehr gut geeignet.

Zur Erhöhung des Wirkungsgrades einer solchen Solarzelle aus GaAs eignet sich ebenfalls eine amorphe oder mikrokristalline Siliziumschicht (4) mit einer Schichtenstruktur gemäß den Figuren 2, 3 und 4. Das Substrat (1) einer Galliumarsenidsolarzelle ist dabei mit ca. $10^{15}$ Atome/cm$^3$ durch beispielsweise Zink p-dotiert und die dünne Oberflächenzone (2) ist durch ca. $4 - 5 \cdot 10^{18}$ Atome/cm$^3$ mit beispielsweise Schwefel n-dotiert.

Durch einen Glimmentladungsprozeß mit Silan ($SiH_4$), Methan ($CH_4$) bzw. Äthylen ($C_2H_4$) und Phosphin ($PH_3$) wird die dotierte, amorphe bzw. mikrokristalline Siliziumschicht (4) hergestellt. Es ist auch ein CVD-Prozeß (Chemical-Vapour-Deposition) möglich. Außerdem kann die amorphe bzw. mikrokristalline Siliziumschicht (4) gesputtert oder aufgedampft werden.

Zum Verschalten der einzelnen Solarzellen zu einer Solarbatterie werden die Kontakte und die Kontaktierungsbereiche der Metallisierung (6) durch ein Ultraschall-Schweißverfahren miteinander verbunden.

Je nach Einsatzart und Wirtschaftlichkeit wird man für den Halbleiterkörper (1), (2) ein- oder polykristallines Ausgangsmaterial verwenden, vorzugsweise für den Einsatz im Weltraum einkristallines und in der Terrestric polykristallines.

## Ansprüche

1. Solarzelle aus einem einen pn-Übergang enthaltenden Halbleiterkörper (1), (2), wobei eine dem Licht zugewandte dünne Oberflächenzone (2) vom einen Leitungstyp eine Metallisierung (6) aufweist, die kammartig ausgebildet ist, einem Rückseitenkontakt (7) und einer reflexionsmindernden Schicht (5), dadurch gekennzeichnet, daß unmittelbar unter der Metallisierung (6) und über der Oberflächenzone (2) eine extrem dünne Schicht (3) aus Siliziumdioxid angeordnet ist und daß eine amorphe oder mikrokristalline Siliziumschicht (4) die Oberfläche der Metallisierung (6) bzw. die Oberfläche der extrem dünnen Schicht (3) aus Siliziumdioxid bedeckt.

2. Solarzelle aus einem einen pn-Übergang enthaltenden Halbleiterkörper (1), (2), wobei eine dem Licht zugewandte dünne Oberflächenzone (2) vom einen Leitungstyp eine Metallisierung (6) aufweist, die kammartig ausgebildet ist, einem Rückseitenkontakt (7) und einer reflexionsmindernden Schicht (5), dadurch gekennzeichnet, daß unmittelbar unter der Metallisierung (6) bzw. unter der reflexionsmindernden Schicht (5) eine extrem dünne Schicht (3) aus Siliziumdioxid angeordnet ist und daß eine amorphe oder mikrokristalline Siliziumschicht (4) zwischen der extrem dünnen Schicht (3) aus Siliziumdioxid und der Oberflächenzone (2) angeordnet ist.

3. Solarzelle nach einem der vorangehenden Ansprüche, dadurch gekennzeichnet, daß die amorphe mikrokristalline Siliziumschicht (4) undotiert oder dotiert ist.

4. Solarzelle nach einem der vorangehenden Ansprüche, dadurch gekennzeichnet, daß zur p- bzw. n-Dotierung der amorphen oder mikrokristallinen Siliziumschicht (4) Stoffe der dritten bzw. fünften Gruppe des Periodensystems verwendet werden.

5. Solarzelle nach einem der vorangehenden Ansprüche, dadurch gekennzeichnet, daß der Halbleiterkörper (1), (2) aus dotiertem Silizium oder Galliumarsenid besteht, wobei der Halbleiterkörper (1), (2) bei Galliumarsenidsolarzellen auf ein Substrat aus GaAs oder Ge aufgebracht ist.

6. Solarzelle nach einem der vorangehenden Ansprüche, dadurch gekennzeichnet, daß der Halbleiterkörper (1), (2) aus ein- oder polykristallinem Silizium oder Galliumarsenid besteht.

7. Solarzelle nach einem der vorangehenden Ansprüche, dadurch gekennzeichnet, daß die reflexionsmindernde Schicht (5) aus Titanoxid, Siliziummonoxid, Siliziumdioxid, Tantaloxid, Nioboxid, Aluminiumoxid bzw. aus der Ein- oder Mehrschichtenkombination dieser Materialien besteht.

8. Solarzelle nach einem der vorangehenden Ansprüche, dadurch gekennzeichnet, daß die Metallisierung (6) unter der reflexionsmindernden Schicht (5) eine Kammstruktur oder eine Doppel-Kammstruktur hat und wie der Rückseitenkontakt (7) aus Aluminium, Silber, Nickel oder Kupfer besteht.

9. Solarzelle nach Anspruch 3, dadurch gekennzeichnet, daß die dünne Oberflächenzone (2) im Falle der undotierten amorphen oder mikrokristallinen Siliziumschicht (4) eine Schichtdicke von ca. 0,5 μm und im Falle der dotierten amorphen oder mikrokristallinen Siliziumschicht (4) eine Schichtdicke von ca. 0,25 μm hat.

10. Solarzelle nach einem der vorangehenden Ansprüche, dadurch gekennzeichnet, daß die Valenzen der amorphen oder mikrokristallinen Siliziumschicht (4) durch Hydrierung mit Wasserstoff abgesättigt sind, daß durch Einbau von Kohlenstoff ein optisches Fenster mit ca. 3 eV Bandabstand vorhanden ist und daß durch Zugabe von Phosphor die Leitfähigkeit dieser Schicht bestimmt ist.

11. Verfahren zur Herstellung einer Solarzelle nach einem der vorangehenden Ansprüche, dadurch gekennzeichnet, daß die amorphe oder mikrokristalline Siliziumschicht (4) durch einen Glimmentladungs- oder CVD (Chemical-Vapour-Deposition)-Prozeß hergestellt, gesputtert oder aufgedampft wird.

12. Verfahren zur Herstellung einer Solarzelle nach einem der vorangehenden Ansprüche, dadurch gekennzeichnet, daß die reflexionsmindernde Schicht (5) thermisch erzeugt, aufgedampft, aufgeschleudert, aufgesprüht, durch Tauchen oder durch einen CVD-Prozeß hergestellt wird.

## Claims

1. Solar cell consisting of a semiconducting body (1), (2) containing a p-n junction, in which a thin surface zone (2) of the one conductive type turned towards the light comprises a metallization (6) which is formed like a comb, of a rear-side contact (7) and of an antireflecting layer (5), characterized in that directly beneath the metallization (6) and above the surface zone (2) an extremely thin layer (3) of silicon dioxide is disposed and that an amorphous or microcrystalline silicon layer (4) covers the surface of the metallization (6) or the surface of the extremely thin layer (3) of silicon dioxide.

2. Solar cell consisting of a semiconducting body (1), (2) containing a p-n junction, in which a thin surface zone (2) of the one conductive type turned towards the light comprises a metallization (8) which is formed like a comb, of a rear-side contact (7) and of an antireflecting layer (5), characterized in that directly beneath the metallization (8) or beneath the antireflecting layer (5) an extremely thin layer (3) of silicon dioxide is disposed and that an amorphous or microcrystalline silicon layer (4) in disposed between the extremely thin layer (3) of silicon dioxide and the surface zone (2).

3. Solar cell according to any one of the preceding claims, characterized in that the amorphous microcrystalline silicon layer (4) is undoped or doped.

4. Solar cell according to any one of the preceding claims, characterized in that for the p- or n-doping of the amorphous or microcrystalline silicon layer (4) substances of the third or fifth group of the periodic system are used.

5. Solar cell according to any one of the preceding claims, characterized in that the semiconducting body (1), (2) consists of doped silicon or gallium arsenide, the semiconducting body (1), (2) being in the case of gallium arsenide solar cells mounted on a substrate of GaAs or Ge.

6. Solar cell according to any one of the preceding claims, characterized in that the semiconducting body (1), (2) consists of mono- or polycrystalline silicon or gallium arsenide.

7. Solar cell according to any one of the preceding claims, characterized in that the antireflecting layer (6) consists of titanium oxide, silicon monoxide, silicon dioxide, tantalum oxide, niobium oxide, aluminium oxide or of a single- or multi-layered combination of these materials,

8. Solar call according to any one of the preceding claims, characterized in that the metallization (6) has beneath the antireflecting layer (5) a comb structure or a double comb structure and like the rear-side contact (7) consists of aluminium, silver, nickel or copper.

9. Solar cell according to claim 3, characterized in that the thin surface zone (2) has in the case of the undoped amorphous or microcrystalline silicon layer (4) a layer thickness of approx. 0.6 μm and in the case or the doped amorphous or microcrystalline silicon layer of approx. 0.25 μm.

10. Solar cell according to any one of the preceding claims, characterized in that the valencies of the amorphous or microcrystalline layer (4) are saturated by hydration with hydrogen, that by the incorporation of carbon an optical window with approx. 3 eV band gap is provided and that by the addition of phosphorus the conductivity of this layer is determined.

11. Method of manufacturing a solar cell according to any one of the preceding claims, characterized in that the amorphous or microcrystalline silicon layer (4) is manufactured by a glow discharge or CVD (chemical vapour deposition) process, by sputtering or by vapour deposition.

12. Method of manufacturing a solar cell according to any one of the preceding claims, characterized in that the antireflecting layer (5) is produced thermally, by vapour deposition, centrifuging or spraying, or manufactured by dipping or a CVD process.

## Revendications

1. Cellule solaire formée d'un corps semi-conducteur (1, 2) contenant une jonction pn et possédant une mince zone superficielle (2) d'un type de conductivité, qui est dirigée vers la lumière et présente une métallisation (6) conformée en peigne, d'un contact arrière (7) et d'une couche antireflet (5), caractérisée en ce qu'une couche (3) extrêmement mince de silice est disposée directement sous la métallisation (6) et par-dessus la zone superficielle (2) et qu'une couche (4) de silicium amorphe ou microcristallin recouvre la surface de la métallisation (6) et la surface de la couche (3) extrêmement mince de silice.

2. Cellule solaire formée d'un corps semi-conducteur (1, 2) contenant une jonction pn et possédant une mince zone superficielle (2) d'un type de conductivité, qui est dirigée vers la lumière et présente une métallisation (6) conformée en peigne, d'un contact arrière (6) et d'une couche antireflet (5), caractérisée en ce qu'une couche (3) extrêmement mince de silice est disposée directement sous la métallisation (6) et sous la couche antireflet (5) et qu'une couche (4) de silicium amorphe ou microcristallin est disposée entre la couche (3) extrêmement mince de silice et la zone superficielle (2).

3. Cellule solaire selon une des revendications précédentes, caractérisée en ce que la couche (4) de silicium amorphe ou microcristallin est dopée ou non.

4. Cellule solaire selon une des revendications précédentes, caractérisée en ce que, pour le dopage p ou n de la couche (4) de silicium amorphe ou microcristallin, on utilise des matériaux du troisième ou du cinquième groupe du système périodique.

5. Cellule solaire selon une des revendications précédentes, caractérisée en ce que le corps semi-conducteur (1, 2) est en silicium ou arséniure de gallium dopé, le corps semi-conducteur (1, 2) étant appliqué sur un substrat en GaAs ou Ge s'il s'agit de cellules solaires à l'arséniure de gallium.

6. Cellule solaire selon une des revendications précédentes, caractérisée en ce que le corps semi-conducteur (1, 2) est formé d'un silicium ou d'arséniure de gallium mono- ou polycristallin.

7. Cellule solaire selon une des revendications précédentes, caractérisée en ce que la couche antireflet (5) est faite d'oxyde de titane, monoxyde de silicium, silice, oxyde de tantale, oxyde de niobium, oxyde d'aluminium ou d'une combinaison de ces matériaux en une ou plusieurs couches.

8. Cellule solaire selon une des revendications précédentes, caractérisée en ce que la métallisation (6) sous la couche antireflet (5) possède une structure en peigne ou en double peigne et est formée, comme le contact arrière (7), d'aluminium, argent, nickel ou cuivre.

9. Cellule solaire selon la revendication 3, caractérisée en ce que la mince zone superficielle (2) possède une épaisseur de couche d'environ 0,5 $\mu$m au cas où la couche (4) de silicium amorphe ou microcristallin n'est pas dopée, et possède une épaisseur de couche d'environ 0,25 $\mu$m au cas où la couche (4) de silicium amorphe ou microcristallin est dopée.

10. Cellule solaire selon une des revendications précédentes, caractérisée en ce que les valences de la couche (4) de silicium amorphe ou microcristallin sont saturées par hydrogénation à l'hydrogène, qu'une fenêtre optique d'un intervalle d'énergie entre deux bandes ou saut d'énergie d'environ 3 eV est formée par introduction de carbone et que la conductivité de cette couche est fixée par l'addition de phosphore.

11. Procédé pour fabriquer une cellule solaire selon une des revendications précédentes, caractérisé en ce que l'on forme la couche (4) de silicium amorphe ou microcristallin par un processus de décharge par effluve ou de dépôt chimique en phase vapeur, par pulvérisation cathodique ou par métallisation.

12. Procédé pour fabriquer une cellule solaire selon une des revendications précédentes, caractérisé en ce que l'on forme la couche antireflet (5) thermiquement, par métallisation, projection, pulvérisation, par immersion ou par un processus de dépôt chimique en phase vapeur.

FIG. 1

FIG. 2

FIG. 3

FIG. 4